# EUROPEAN PATENT APPLICATION

(11) **EP 3 330 414 A1**
(43) Date of publication of application: **06.06.2018**
(21) Application number: 16832926.6
(22) Date of filing: 29.07.2016
(51) Int. Cl.: C30B 29/04

(54) **DIAMOND SUBSTRATE AND METHOD FOR PRODUCING DIAMOND SUBSTRATE**

(30) Priority: 31.07.2015 JP 2015152545
(71) Applicant: Adamant Namiki Precision Jewel Co., Ltd., Tokyo 128-8511 (JP)
(72) Inventor: AIDA Hideo, Tokyo 123-8511 (JP); KOYAMA Koji, Tokyo 123-8511 (JP); IKEJIRI Kenjiro, Tokyo 123-8511 (JP); KIM Seongwoo, Tokyo 123-8511 (JP); KIKUCHI Yuki, Tokyo 123-8511 (JP)
(74) Representative: Hoffmann Eitle
(86) International application number: PCT/JP2016/072246
(87) International publication number: WO 2017/022647

(57) **Abstract**

Provided is a self-support diamond substrate made of diamond and a method for producing such a diamond substrate in which the amount of warpage is reduced and variation of angle of the crystal axis over the entire substrate surface is reduced. A foundation substrate is prepared, several pieces of columnar diamond made of diamond single crystal are formed over one surface of the foundation substrate, the diamond single crystal is grown from the tip of each piece of columnar diamond, each piece of diamond single crystal grown from the tip of each piece of columnar diamond is brought into coalescence to form a diamond substrate layer, the diamond substrate layer is separated from the foundation substrate, and the diamond substrate is produced from the diamond substrate layer. The difference between the highest point and the lowest point in the thickness direction of the diamond substrate is more than 0 µm and 485 µm or less and the variation of the angle of the crystal axis over the entire surface of the diamond substrate is more than 0° and 3.00° or less.

## Description

### TECHNICAL FIELD

The present invention relates to a diamond substrate and a method for producing a diamond substrate.

### BACKGROUND ART

Since diamond has many superior characteristics as a semiconductor material unlike other materials, it is expected as an ultimate semiconductor substrate. In recent years in particular, diamond thin film devices have been developed such as ultraviolet emitting element utilizing wide bandgap and field effect transistor with good high-frequency characteristics.

The diamond thin film device described above is produced by plasma CVD (Chemical Vapor Deposition). At that time, metal, silicon, and the like can be used as a foundation substrate for a diamond thin film to grow. Moreover, in order to obtain a diamond thin film with high crystallinity, it is preferable that a diamond substrate be used as a foundation substrate to be homoepitaxially grown, and thereby it becomes possible to improve characteristics of the diamond thin film device.

In order to obtain a high-quality and uniform diamond thin film, appropriate growth conditions and a diamond substrate appropriate for the conditions as a foundation substrate are required. In order to obtain a uniform diamond thin film, film formation condition needs to be uniform over the diamond substrate as the foundation substrate. When a diamond thin film is grown by a plasma CVD method, the substrate temperature is kept constant by taking a balance between heating by plasma and cooling by water cooling stage. At that time, in the case in which the irregularity of the diamond substrate as the foundation substrate is remarkable, contact with a cooling stage becomes ununiform and the temperature of the diamond substrate during growth becomes ununiform. As a result, quality of the diamond thin film grown on the foundation substrate becomes ununiform.

In order to carry out preferable homoepitaxial growth, as disclosed in Non-Patent Literature 1, it is reported that angle variation of the crystal axis of the diamond substrate as the foundation substrate is preferably within 3.5° ± 1.5°.

That is, in order to uniformly grow a high-quality diamond thin film, the irregularity of the diamond substrate as the foundation substrate needs to be small and the uniformity of the angle variation of the crystal axis in the diamond substrate is required to be high.

Now, a HTHP (High Temperature High Pressure) method is mainly used as a method for producing a diamond substrate as a foundation substrate, and most of artificial diamond in the market is produced by this method.

The in-plane uniformity of the temperature and the off angle is secured by using a foundation diamond substrate produced by an HTHP method, and a high-quality diamond thin film is produced. However, when diamond is to be used as a semiconductor device, a diamond substrate with large area with the diameter of 2 inches (about 50 mm) or more is required as a foundation substrate in terms of producibility of the device. However, it has not been possible to produce a diamond substrate with large area by a typical HTHP method. In order to solve this problem, heteroepitaxial growth for growing large-area diamond crystal for a foundation substrate on an MgO substrate has been developed, and large-area diamond substrate is becoming realistic.

### CITATION LIST

### PATENT LITERATURE

Non-Patent Literature 1: Further improvement in high crystalline quality of homoepitaxial CVD diamond, H. Miyake, K. Arima, O. Maida, T. Teraji and T. Ito, 16(2007) 679-684.

### SUMMARY OF THE INVENTION

### PROBLEMS TO BE SOLVED BY THE INVENTION

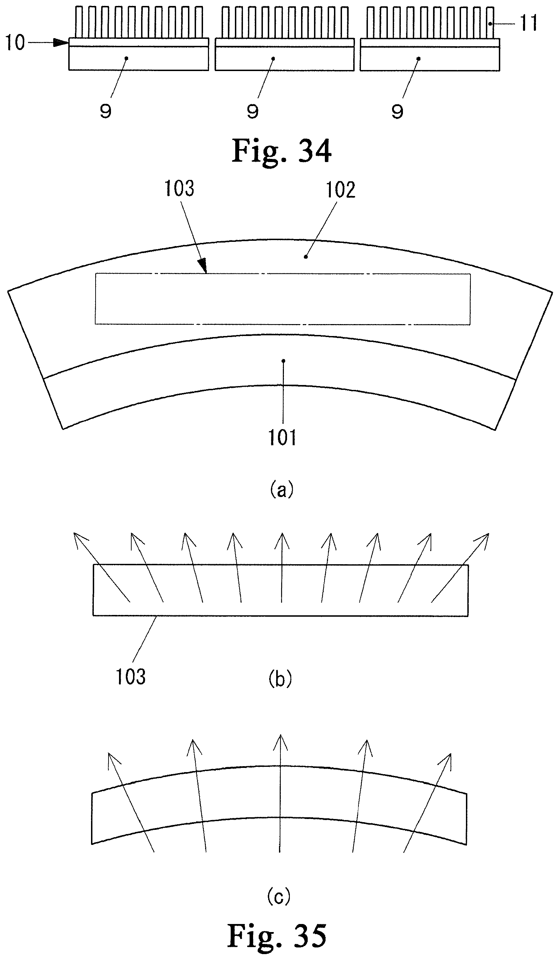

In order to achieve a diamond substrate with large area, heteroepitaxial growth technique is under development. However, a diamond substrate with less irregularity and high in-plane uniformity of the angle variation of the crystal axis has not been achieved yet. This is because, when diamond crystal with large area is to be produced by a heteroepitaxial growth method, the diamond crystal grown on the foundation substrate is warped by a difference in thermal expansion coefficient and lattice constant with the foundation substrate. As illustrated in Fig. 35(a), when the warped diamond crystal is processed in a substrate shape, the surface of the processed diamond substrate becomes flat surface without warpage as illustrated in Fig. 35(b), but angle of the in-plane crystal axis varies. In this case, even if the medium value of the angle of the crystal axis in the diamond substrate is adjusted by processing, there will be an area outside 3.5° ± 1.5° in the case in which the angle variation of the crystal axis in the substrate is 3° or more, and the quality of the diamond thin film is lowered.

When the surface is polished according to the shape of the warped diamond substrate, the angle variation of the crystal axis of the processed diamond substrate surface becomes as illustrated in Fig. 35(c). Although it seems that the angle of the crystal axis varies, the angle between the actual surface of the diamond substrate and the crystal axis is uniform in a microscopic view, and the in-plane uniformity of the angle variation of the crystal axis is high in terms of crystal growth. Meanwhile, with respect to the shape of the diamond substrate, warpage before the process is kept even after the process.

Therefore, in order to uniformly grow a good-quality diamond thin film, irregularity of the diamond substrate as the foundation substrate needs to be small and the uniformity of the angle variation of the crystal axis in the diamond substrate is required to be high.

The present invention has been developed in consideration of the circumstances described above, and the object thereof is to provide a diamond substrate made of diamond single crystal in which the difference between the highest point and the lowest point in the thickness direction of the substrate can be reduced to a predetermined range (more than 0 µm and 485 µm or less) and the variation of the angle of the crystal axis over the entire substrate surface can be reduced to a predetermined range (more than 0° and 3.00° or less), and a method for producing such a substrate.

### Solutions to the Problems

The problem descried above is solved by the following present invention. That is, a diamond substrate according to the present invention is made of diamond single crystal in which the difference between the highest point and the lowest point in the thickness direction of the diamond substrate is more than 0 µm and 485 µm or less and the variation of the angle of the crystal axis over the entire surface of the diamond substrate is more than 0° and 3.00° or less.

In addition, a method for producing a diamond substrate according to the present invention includes: preparing a foundation substrate; forming several pieces of columnar diamond made of diamond single crystal on one surface of the foundation substrate; growing diamond single crystal from the tip of each piece of columnar diamond; forming a diamond substrate layer by bringing each diamond single crystal grown from the tip of each piece of columnar diamond into coalescence; and separating the diamond substrate layer from the foundation substrate to produce a diamond substrate from a diamond substrate layer, in which the difference between the highest point and the lowest point in the thickness direction of the diamond substrate is more than 0 µm and 485 µm or less and the variation of the angle of the crystal axis over the entire surface of the diamond substrate is more than 0° and 3.00° or less.

### EFFECTS OF THE INVENTION

By the characteristics described above, in a diamond substrate and a method for producing the same according to the present invention, it becomes possible to reduce the difference between the highest point and the lowest point in the thickness direction of the diamond substrate to more than 0 µm and 485 µm or less in advance, and it becomes possible to reduce the angle variation of the crystal axis over the entire diamond substrate surface to more than 0° and 3.00° or less. Therefore, since it is possible to reduce influence of the variation of the crystal axis of the diamond substrate to the crystal axis of the semiconductor film formed over the entire surface of the diamond substrate, the angle variation of the crystal axis of the semiconductor film is reduced and it becomes to reduce occurrence of in-plane variation of characteristics of the semiconductor film. At the same time, since it becomes possible to keep the temperature in the diamond substrate more constant when heating a functional thin film (for example, semiconductor film and the like) in formation thereof, it becomes possible to reduce occurrence of in-plane variation of characteristics of the semiconductor film.

### BRIEF DESCRIPTION OF THE DRAWINGS

Fig. 1 is a perspective view schematically illustrating one example of diamond substrate according to the present embodiment.
Fig. 2 is a side cross-sectional view schematically illustrating one example of warpage of the diamond substrate according to the present embodiment and crystal axis over the entire substrate surface.
Fig. 3 is a side cross-sectional view schematically illustrating another example of warpage of the diamond substrate according to the present embodiment and crystal axis over the entire substrate surface.
Fig. 4 is a side cross-sectional view schematically illustrating still another example of warpage of the diamond substrate according to the present embodiment and crystal axis over the entire substrate surface.
Fig. 5 schematically illustrates a foundation substrate according to the first embodiment of a method for producing a diamond substrate according to the present embodiment.
Fig. 6 schematically illustrates a state of the foundation substrate with a diamond layer according to the first embodiment of a method for producing a diamond substrate.
Fig. 7 is a schematic diagram illustrating a foundation substrate with several pieces of columnar diamond formed.
Fig. 8 is a perspective view illustrating a foundation substrate with several pieces of columnar diamond formed.
Fig. 9 is a schematic diagram illustrating a foundation substrate with columnar diamond where a diamond substrate layer is formed.
Fig. 10 is a perspective view illustrating a foundation substrate with columnar diamond where a diamond substrate layer is formed.
Fig. 11 schematically illustrates a diamond substrate layer, a foundation substrate, and each piece of columnar diamond warped in convex shape by tensile stress.
Fig. 12 is a schematic diagram illustrating breakage of columnar diamond and separation of a diamond substrate layer and a foundation substrate.
Fig. 13 is a schematic diagram illustrating another mode of a foundation substrate with several pieces of columnar diamond formed.
Fig. 14 is a side view schematically illustrating one example of foundation substrate according to the second embodiment of the method for producing a diamond substrate according to the present embodiment.
Fig. 15 is a plan view illustrating the foundation substrate illustrated in Fig. 14.
Fig. 16 is a side view schematically illustrating another example of foundation substrate according to the second embodiment of the method for producing a diamond substrate.
Fig. 17 is a plan view illustrating the foundation substrate illustrated in Fig. 16.
Fig. 18 is a side view schematically illustrating one example of foundation substrate with a diamond layer according to the second embodiment of the method for producing a diamond substrate.
Fig. 19 is a side view illustrating one example of a method for producing single foundation substrate.
Fig. 20 is a side view schematically illustrating another example of foundation substrate with a diamond layer according to the second embodiment of the method for producing a diamond substrate.
Fig. 21 is a side view schematically illustrating still another example of foundation substrate with a diamond layer according to the second embodiment of the method for producing a diamond substrate.
Fig. 22 is a side view schematically illustrating one example of foundation substrate with several pieces of columnar diamond formed.
Fig. 23 is a side view schematically illustrating another example of foundation substrate with several pieces of columnar diamond formed.
Fig. 24 is a side view schematically illustrating still another example of foundation substrate with several pieces of columnar diamond formed.
Fig. 25 is a perspective view schematically illustrating a state in which several pieces of columnar diamond are formed on one of the several foundation substrates.
Fig. 26 is a side view schematically illustrating one example of foundation substrate with columnar diamond with a diamond substrate layer formed.
Fig. 27 is a side view schematically illustrating another example of foundation substrate with columnar diamond with a diamond substrate layer formed.
Fig. 28 is a side view schematically illustrating still another example of foundation substrate with columnar diamond with a diamond substrate layer formed.
Fig. 29 is a side view schematically illustrating one example of breakage of columnar diamond and separation of a diamond substrate layer and a foundation substrate.
Fig. 30 is a side view schematically illustrating another example of breakage of columnar diamond and separation of a diamond substrate layer and a foundation substrate.
Fig. 31 is a side view schematically illustrating still another example of breakage of columnar diamond and separation of a diamond substrate layer and a foundation substrate.
Fig. 32 is a side view schematically illustrating one example of another mode of foundation substrate with several pieces of columnar diamond formed.
Fig. 33 is a side view schematically illustrating another example of another mode of foundation substrate with several pieces of columnar diamond formed.
Fig. 34 is a side view schematically illustrating still another example of another mode of foundation substrate with several pieces of columnar diamond formed.
Fig. 35(a) schematically illustrates a state of a foundation substrate and diamond in a heteroepitaxial growth method.
Fig. 35(b) is a schematic diagram illustrating one example of angle of the crystal axis of the diamond substrate taken from the diamond of Fig. 35(a).
Fig. 35(c) is a schematic diagram illustrating angle variation of the crystal axis on the diamond substrate surface polished according to the shape of the warped diamond substrate.

### DESCRIPTION OF EMBODIMENTS

The first characteristic of the present embodiment is that, a diamond substrate is made of diamond single crystal, the difference between the highest point and the lowest point in the thickness direction of the diamond substrate is more than 0 µm and 485 µm or less, and variation of angle of the crystal axis over the entire surface of the diamond substrate is more than 0° and 3.00° or less. According to this configuration, since it is possible to reduce influence of variation of the crystal axis of the diamond substrate to the crystal axis of the semiconductor film formed over the entire surface of the diamond substrate, angle variation of the crystal axis of the semiconductor film is reduced and it becomes possible to reduce occurrence of in-plane variation of the characteristics of the semiconductor film. At the same time, since it becomes possible to keep the temperature in the diamond substrate more constant when heating a functional thin film (for example, semiconductor film and the like) in formation thereof, it becomes possible to reduce occurrence of in-plane variation of the characteristics of the semiconductor film. Note that, in the present invention, the thickness direction refers to the normal direction perpendicular to the plane direction of the highest point of a diamond substrate 1 (tangential direction of the highest point surface).

The second characteristic is that the difference is more than 0 µm and 130 µm or less and the variation of the angle of the crystal axis is more than 0° and 0.59° or less. According to this configuration, it becomes possible to reduce the inclination angle of the crystal plane inside the substrate at both edges of the diamond substrate with the diameter of 2 inches, for example, to about 1°. Therefore, it becomes possible to reduce the variation of the angle of the crystal axis to more than 0° and 0.59° or less. Therefore, it becomes possible to further reduce occurrence of in-plane variation of the characteristics of the semiconductor film formed over the entire surface of the diamond substrate. At the same time, since it becomes possible to keep the temperature in the diamond substrate more constant when heating a functional thin film (for example, semiconductor film and the like) in formation thereof, it becomes possible to reduce occurrence of in-plane variation of the characteristics of the semiconductor film. Note that, in the present invention, the range of diameter between 49.8 mm and 50.8 mm (both inclusive) obtained by subtracting 1.0 mm which is equivalent to 2% of 50.8 mm is regarded as 2 inches.

The third characteristic is that the difference is more than 0 µm and 65 µm or less and the variation of the angle of the crystal axis is more than 0° and 0.30° or less. According to this configuration, it becomes possible to reduce the inclination angle of the crystal plane inside the substrate at both edges of the diamond substrate with the diameter of 2 inches, for example, to about 0.5°. Therefore, it becomes possible to reduce the variation of the angle of the crystal axis to more than 0° and 0.30° or less. Therefore, it becomes possible to reduce occurrence of in-plane variation of the characteristics of the semiconductor film formed over the entire surface of the diamond substrate more than any other modes. At the same time, since it becomes possible to keep the temperature in the diamond substrate more constant when heating a functional thin film (for example, semiconductor film and the like) in formation thereof, it becomes possible to reduce occurrence of in-plane variation of the characteristics of the semiconductor film.

The fourth characteristic is that the diamond substrate is simply warped from the outer edge toward the center and the difference is the amount of warpage of the outer edge and the center. According to this configuration, it becomes possible to reduce polishing cost and the amount of processing.

The fifth characteristic is that the diamond substrate is not-simply warped from the outer edge toward the center and the difference is the amount of warpage of the outer edge and the highest point. According to this configuration, since it becomes possible to polish with large stress, it is possible to reduce polishing time.

The sixth characteristic is that the diamond substrate has wave. According to this configuration, since it is possible to reduce the amount of warpage, it is possible to prevent occurrence of crack of the substrate when being polished. In addition, since it becomes possible to polish with large stress, it is possible to reduce polishing time. At the same time, it is possible to reduce variation of the characteristics of the semiconductor element by reducing the angle variation of the crystal axis. At the same time, since it becomes possible to keep the temperature in the diamond substrate more constant when heating a functional thin film (for example, semiconductor film and the like) in formation thereof, it is possible to reduce occurrence of in-plane variation of the characteristics of the semiconductor film. Note that, in the present invention, wave refers to a state in which there are at least one warpage in the convex direction and one warpage in the depression direction and there are convex and depression over the entire substrate in the thickness direction of the substrate when the diamond substrate is seen from the side surface.

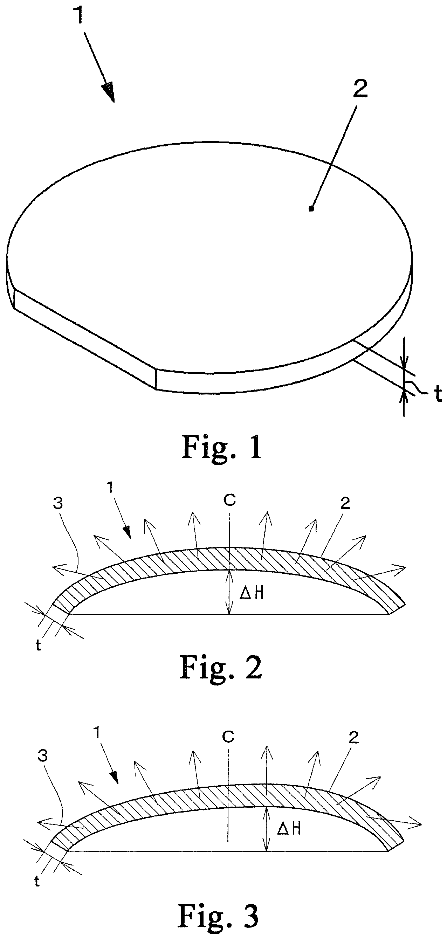

Hereinafter, a diamond substrate according to the present invention will be described in detail with reference to Fig. 1. The shape of the diamond substrate in the plane direction according to the present invention may be square. However, in terms of easy handling in a process for producing surface acoustic wave element, thermistor, semiconductor device, and the like, circular shape is preferable. In particular, as illustrated in Fig. 1, circular shape with an orientation flat surface is preferable.

In the case in which the shape of the diamond substrate 1 (hereinafter simply referred to as "substrate 1" as necessary) is circular shape or circular shape with an orientation flat surface, the diameter is preferably 0.4 inches (about 10 mm) or more in terms of increase in size. Moreover, in terms of increase in size of the substrate in practical use, the diameter is preferably 2 inches (about 50.8 mm) or more, more preferably 3 inches (about 76.2 mm) or more, and further more preferably 6 inches (about 152.4 mm) or more. Note that, in consideration of dimension tolerance of the diamond substrate 1, in the present application, the range of diameter between 49.8 mm and 50.8 mm (both inclusive) obtained by subtracting 1.0 mm which is equivalent to 2% of 50.8 mm is regarded as 2 inches.

Note that, although the upper limit value of the diameter is not particularly limited, 8 inches (about 203.2 mm) or less is preferable in terms of practical use. In addition, in order to produce many elements and devices at the same time, a square diamond substrate with the area equivalent to diameter of 2 inches or more may be used.

In addition, although the thickness t of the diamond substrate 1 may be any number, 3.0 mm or less is preferable as self-support substrate, 1.5 mm or less is more preferable for use in production line of elements and devices, and 1.0 mm or less is further more preferable. On the other hand, although the lower limit value of thickness t is not particularly limited, in terms of securing stiffness of the diamond substrate 1 and prevention of occurrence of crack and rupture, 0.05 mm or more is preferable and 0.3 mm or more is more preferable.

Here, "self-support substrate" in the present invention refers to a substrate that can keep its shape and has the strength not causing inconvenience in handling. In order to have such strength, the thickness t is preferably 0.3 mm or more. In addition, since diamond is an extremely rigid material, the upper limit of the thickness t as self-support substrate is preferably 3.0 mm or less in consideration of possibility of cleavage and the like after formation of element and device. Note that, the thickness t is most preferably 0.5 mm or more and 0.7 mm or less (500 µm or more and 700 µm or less) as the thickness of self-support substrate that is the most commonly used for element and device.

Diamond crystal for forming the diamond substrate 1 is preferably diamond single crystal. Although diamond single crystal is any of Ia type, Ib type, IIa type, and IIb type, Ia type is more preferable in terms of the amount of occurrence of crystal defect and skew and large FWHM (full width at half maximum) of X-ray rocking curve when the diamond substrate 1 is used as a substrate of a semiconductor device. Moreover, the diamond substrate 1 is made of single diamond single crystal and there is no linkage boundary of linkage of several pieces of diamond single crystal on a surface 2.

The surface 2 of the diamond substrate 1 is subject to lapping, polishing, or CMP (Chemical Mechanical Polishing). On the other hand, the back surface of the diamond substrate 1 is lapped and/or polished. The surface 2 and the back surface are preferably processed on the same conditions so that flatness as a substrate is secured more. The surface 2 is processed mainly to obtain flat substrate shape and the back surface is processed mainly to obtain desirable thickness t. Moreover, since the surface roughness Ra of the surface 2 is preferably sufficient to form an element or a device, it is preferably less than 1 nm and it is more preferably 0.1 nm or less to obtain flatness in molecule level. Ra is measured by surface roughness measurement instrument.

In the case in which the diamond substrate 1 is single crystal, the plane direction of the crystal plane of the surface 2 is any of (111), (110), and (100) and it is not limited to these types of plane direction.

In the case in which the diamond substrate 1 is made of single diamond single crystal, since there is not linkage boundary of linkage of several pieces of diamond single crystal on the surface 2, deterioration of crystal quality at the boundary is prevented. Therefore, in the case in which the diamond substrate 1 is made of single diamond single crystal, FWHM (full width at half maximum) of the rocking curve by the X-ray described above in the surface 2 (in particular (100)) can be 300 seconds or less over the entire surface 2.

Moreover, FWHM can be 100 seconds or less and more preferably 50 seconds or less over the entire surface 2. Therefore, it becomes possible to provide the diamond substrate 1 with higher quality.

As for the appearance of the diamond substrate 1 according to the present embodiment, while the surface 2 and the back surface are formed in flat plate shape that is flatly and parallelly formed, the shape seen from the side surface is largely classified into three shapes and it has any of the three shapes.

As illustrated in Fig. 2, the first shape is that the diamond substrate 1 is simply warped from the outer edge toward the center and is symmetrically and simply warped from the center axis C of the substrate 1 when seen from the side surface of the substrate 1. Diamond is an extremely rigid and hard-to-process material. However, it becomes possible to reduce polishing cost and the amount of processing by simply warping the diamond substrate 1.

As illustrated in Fig. 3, the second shape is that the diamond substrate 1 is not-simply warped from the outer edge toward the center and is asymmetrically and not-simply warped from the center axis C of the substrate 1 when seen from the side surface of the substrate 1. As described, since it becomes possible to polish with large stress by not-simply warping the diamond substrate 1, it is possible to reduce polishing time.

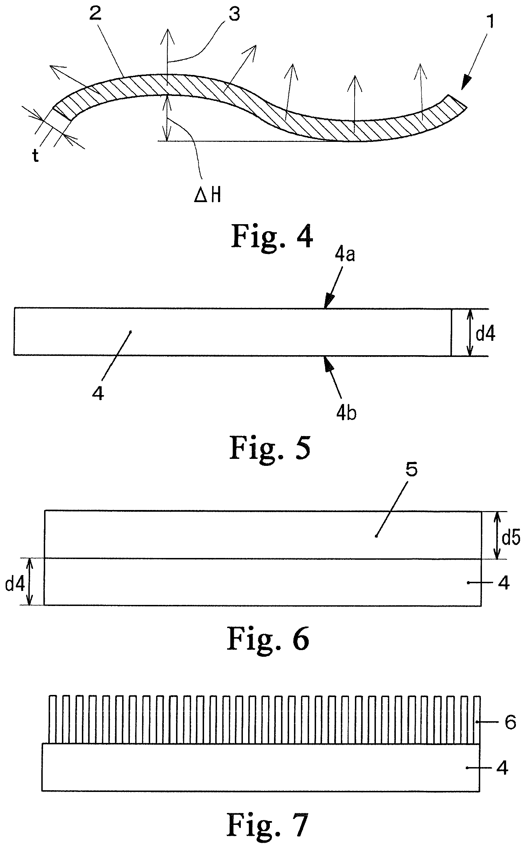

As illustrated in Fig. 4, the third shape is that the diamond substrate 1 has wave. Note that, wave refers to a state in which there are at least one warpage in the convex direction and one warpage in the depression direction and there are convex and depression over the entire substrate in the thickness direction of the substrate 1 when the substrate 1 is seen from the side surface. With the diamond substrate 1 having wave, since it is possible to reduce the amount of warpage, it is possible to prevent occurrence of crack of the substrate when being polished. In addition, since it becomes possible to polish with large stress, it is possible to reduce polishing time. At the same time, it is possible to reduce variation of the characteristics of the semiconductor element by reducing angle variation of a crystal axis 3. At the same time, since it becomes possible to keep the temperature in the diamond substrate more constant when heating a functional thin film (for example, semiconductor film and the like) in formation thereof, it becomes possible to reduce occurrence of in-plane variation of the characteristics of the semiconductor film.

Moreover, with respect to the diamond substrate 1 according to the present invention with each warpage shape and wave illustrated in Figs. 2 to 4, the difference between the highest point and the lowest point in the thickness direction of the substrate 1 is set to more than 0 µm and 485 µm or less and the variation of the angle of the crystal axis 3 over the entire surface 2 of the diamond substrate 1 is more than 0° and 3.00° or less.

The difference in the diamond substrate 1 illustrated in Fig. 2 is the amount of warpage ΔH of the outer edge and the center. That is, in the shape of warpage of the substrate 1 illustrated in Fig. 2, the back surface point in the center of the substrate 1 is the highest point in the thickness direction and the outer edge is the lowest point.

On the other hand, the difference in the diamond substrate 1 illustrated in Fig. 3 is the amount of warpage ΔH of the outer edge and the highest point described above. In the diamond substrate 1 illustrated in Fig. 3, the highest point is not always the center of the substrate. In the shape of warpage of the substrate 1 illustrated in Fig. 2, the difference between the back surface point of the highest point and the outer edge in the thickness direction is the amount of warpage ΔH.

Moreover, the difference in the diamond substrate 1 illustrated in Fig. 4 is the difference between the highest point and the lowest point associated with wave in the thickness direction of the diamond substrate 1. In the diamond substrate 1 illustrated in Fig. 4, the difference between the back surface point of the highest point and the back surface point of the lowest point in the thickness direction is the amount of warpage ΔH.

Note that, "thickness direction" in the present application is defined as the normal direction perpendicular to the plane direction of the highest point (tangential direction at the highest point) of the diamond substrate 1.

In addition, the variation of the angle of the crystal axis 3 over the entire surface 2 of the substrate 1 is more than 0° and 3.00° or less.

With respect to the diamond substrate 1 according to the present invention, the shape with such warpage or wave and the variation of the angle of the crystal axis 3 over the entire substrate 1 are allowed. However, the difference between the highest point and the lowest point described above and the angle variation of the crystal axis 3 over the substrate 1 are within a certain range.

Because it is possible to reduce influence of the variation of the crystal axis 3 of the diamond substrate 1 to the crystal axis of the semiconductor film formed over the entire surface of the diamond substrate 1 by reducing the angle variation of the crystal axis 3 over the entire surface of the diamond substrate 1 to more than 0° and 3.00° or less, the angle variation of the crystal axis of the semiconductor film is reduced and it becomes possible to reduce occurrence of in-plane variation of the characteristics of the semiconductor film. In particular, it is effective in the diamond substrate with the thickness t of 0.5 mm or more and 0.7 mm or less which is most commonly used for forming an element or a device or growing diamond single crystal. At the same time, since it becomes possible to keep the temperature in the diamond substrate more constant when heating a functional thin film (for example, semiconductor film and the like) in formation thereof by reducing the difference to more than 0 µm and 485 µm or less, it becomes possible to reduce occurrence of in-plane variation of the characteristics of the semiconductor film.

In the case in which the angle variation of the crystal axis 3 is more than 3.00°, it is not possible to reduce occurrence of in-plane variation of the characteristics of the semiconductor film. Moreover, in the case in which the difference of the substrate 1 is more than 485 µm, in-plane uniformity of the substrate temperature is lowered since the distance from the heater is different depending on points when heating the diamond substrate 1, and it is not possible to reduce occurrence of in-plane variation of the characteristics of the semiconductor film.

Note that, the variation of the angle of the crystal axis 3 is obtained by measuring the curvature of the crystal plane inside the diamond substrate 1 by atomic force microscope (AFM) or X-ray diffraction. Although the crystal plane inside the substrate 1 is any plane, (001) is listed as an example.

Moreover, it becomes possible to reduce the inclination angle of the crystal plane inside the substrate 1 between the both edges of the diamond substrate 1 with the diameter of 2 inches, for example, to about 1° by reducing the difference of the substrate 1 to more than 0 µm and 130 µm or less. Therefore, it becomes possible to reduce the variation of the angle of the crystal axis 3 to more than 0° and 0.59° or less. Therefore, it becomes possible to further reduce occurrence of in-plane variation of the characteristics of the semiconductor film formed over the entire surface of the diamond substrate 1. At the same time, since it becomes possible to keep the temperature in the diamond substrate more constant when heating a functional thin film (for example, semiconductor film and the like) in formation thereof, it is possible to reduce occurrence of in-plane variation of the characteristics of the semiconductor film.

Moreover, it becomes possible to reduce the inclination angle of the crystal plane inside the substrate 1 between the both edges of the diamond substrate 1 with the diameter of 2 inches, for example, to about 0.5° by reducing the difference of the substrate 1 to more than 0 µm and 65 µm or less. Therefore, it becomes possible to reduce the variation of the angle of the crystal axis 3 to more than 0° and 0.30° or less. Therefore, it becomes possible to reduce occurrence of in-plane variation of the characteristics of the semiconductor film formed over the entire surface of the diamond substrate 1 more than any other modes. In addition, at the same time, since it becomes possible to keep the temperature in the diamond substrate more constant when heating a functional thin film (for example, semiconductor film and the like) in formation thereof, it becomes possible to reduce occurrence of in-plane variation of the characteristics of the semiconductor film.

As a result of study, the inventors of the present application have found that not only reduction of the amount of warpage of the substrate 1 (difference between the highest point and the lowest point in the thickness direction of the substrate 1) but also reduction of angle variation of the crystal axis 3 over the entire surface 2 of the substrate 1 is required at the same time in production of the self-support diamond substrate 1. Moreover, the inventors have found that the difference and the numerical range of the angle variation of the crystal axis 3 effective for reduction of occurrence of in-plane variation of the characteristics of the semiconductor film formed over the surface 2 of the substrate 1 are more than 0 µm and 485 µm or less, and more than 0° and 3.00° or less, respectively.

Next, the first embodiment of a method for producing a diamond substrate according to the present embodiment will be described in detail with reference to Figs. 5 to 12. First, as illustrated in Fig. 5, a foundation substrate 4 is prepared. The material of the foundation substrate 4 is, for example, magnesium oxide (MgO), aluminum oxide (α-Al₂O₃: sapphire), Si, quartz, platinum, iridium, strontium titanate (SrTiO₃), or the like.

With respect to the foundation substrate 4, at least one with one surface 4a mirror-polished is used. In the process of growth of a diamond layer described later, a diamond layer is grown and formed over the side that is mirror-polished (over the surface of one surface 4a).

It is preferable that mirror-polishing be performed generally with the surface roughness Ra of 10 nm or less. In the case in which Ra of one surface 4a is over 10 nm, quality of the diamond layer to be grown over one surface 4a is lowered. Ra is measured by a surface roughness measurement instrument.

After the foundation substrate 4 is prepared, as illustrated in Fig. 6, a diamond layer 5 made of diamond single crystal is grown and formed over one surface 4a. Method for growing the diamond layer 5 is not particularly limited and a known method can be used. As specific examples of method for growing, a vapor-phase growth method such as pulsed laser deposition (PLD) method and chemical vapor deposition (CVD) method or the like is preferably used.

Note that, before the growth of the diamond layer 5, an iridium (Ir) single crystal film may be formed over the surface of the foundation substrate 4 as pre-process and the diamond layer 5 may be grown and formed over the Ir single crystal film.

The thickness d5 of the diamond layer 5 illustrated in Fig. 6 is preferably set to the height of columnar diamond to be grown and it is preferably grown with the thickness of 30 µm or more and 500 µm or less.

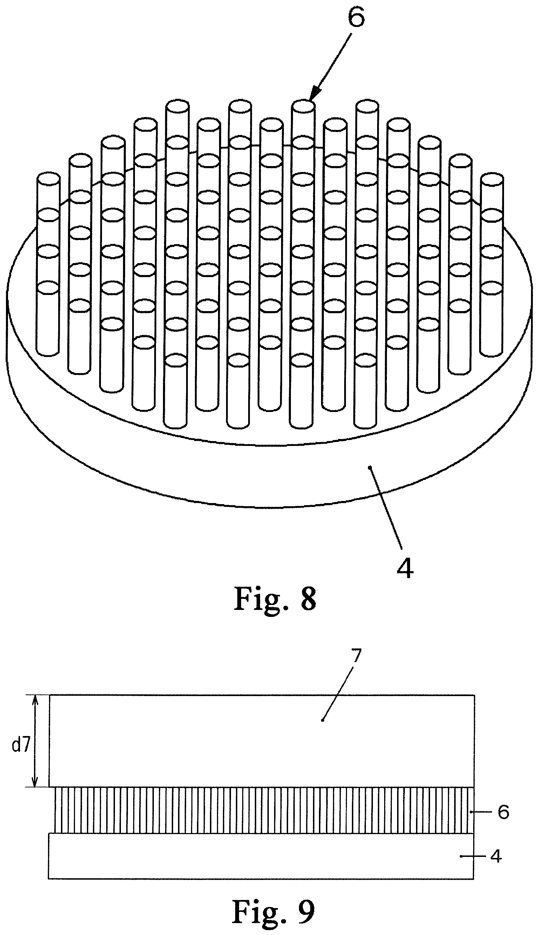

Next, as illustrated in Figs. 7 and 8, several pieces of columnar diamond 6 are formed from the diamond layer 5. The columnar diamond 6 may be formed by etching, photolithography, laser, or the like.

Because the diamond layer 5 is formed over the foundation substrate 4 by heteroepitaxial growth, while many crystal defects are formed in the diamond layer 5, it becomes possible to reduce the number of defects by forming the several pieces of columnar diamond 6.

Next, a diamond substrate layer 7 is grown and formed at the tip of the columnar diamond 6. It is possible to uniformly grow diamond single crystal from every columnar diamond 6 by growing diamond single crystal from the tip of each piece of columnar diamond 6. Then, it becomes possible to start coalescence of the diamond single crystal grown from each piece of columnar diamond 6 at the same timing by growing in the lateral direction against the height direction of each piece of columnar diamond 6.

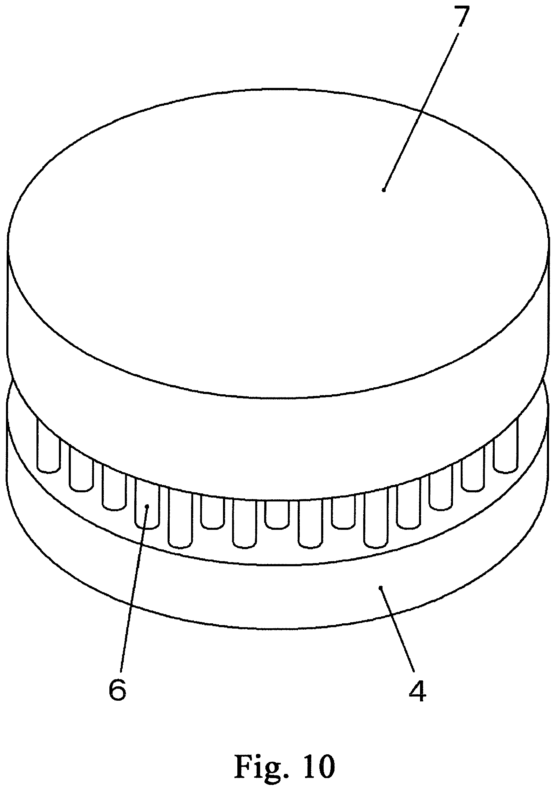

The diamond substrate layer 7 is formed as illustrated in Figs. 9 and 10 by bringing diamond single crystal grown from each piece of columnar diamond 6 into coalescence. The number of the columnar diamond 6 that can be formed varies according to the diameter of the foundation substrate 4 and it is possible to increase the number of the columnar diamond 6 as the diameter of the foundation substrate 4 is increased.

Moreover, quality of the surface of the diamond substrate layer 7 is improved by setting the pitch between pieces of the columnar diamond 6 to the distance (pitch) to be the same as in growth of nucleus of diamond single crystal and growing diamond single crystal from each piece of columnar diamond, and it becomes possible to achieve FWHM of 300 seconds or less over the entire surface.

Moreover, FWHM can be 100 seconds or less and more preferably 50 seconds or less over the entire surface.

Note that, quality of the surface of the diamond substrate layer 7 is improved by setting the diameter and the pitch of the columnar diamond 6 to 10 µm or less and it has become possible to achieve FWHM of 300 seconds or less.

After the diamond substrate layer 7 is formed, the diamond substrate layer 7 is separated from the foundation substrate 4 at the columnar diamond 6. In the present embodiment, stress is applied to the columnar diamond 6 by warpage occurred to the foundation substrate 4 and the diamond substrate layer 7 when the diamond substrate layer 7 is grown and the columnar diamond 6 is broken by the stress to separate the diamond substrate 7 from the foundation substrate 4.

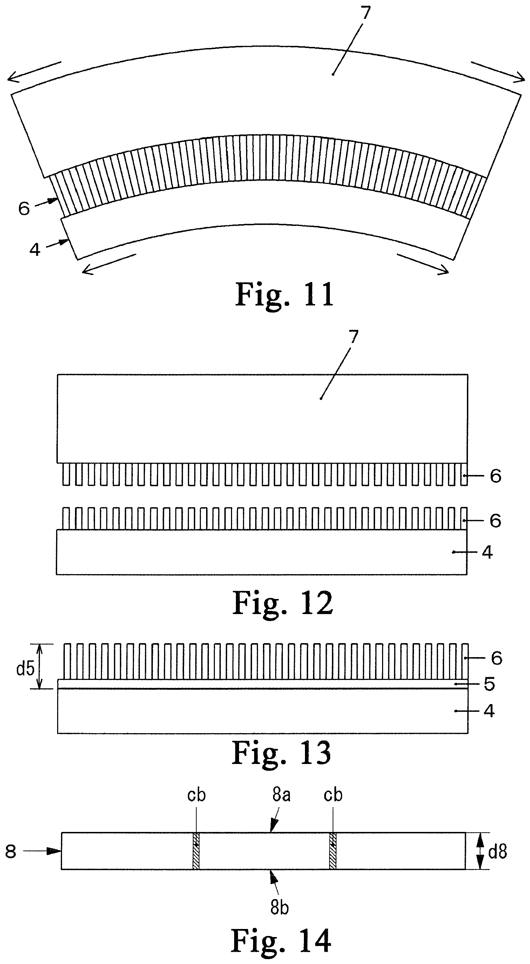

For example, as illustrated in Fig. 11, thermal expansion coefficient and lattice multiplier of the foundation substrate 4 made of MgO single crystal are larger than those of the diamond substrate layer 7 made of diamond single crystal. Therefore, tensile stress as indicated by arrows is generated from the center toward the edge on the diamond substrate layer 7 when the diamond substrate layer 7 is cooled after being grown. The tensile stress is generated by stress generated by the difference between lattice constant of the foundation substrate 4 and that of the diamond substrate layer 7 and/or difference between thermal expansion coefficient of the foundation substrate 4 and that of the diamond substrate layer 7. As a result, as illustrated in Fig. 8, the diamond substrate layer 7, the foundation substrate 4, and each piece of columnar diamond 6 in their entirety are warped so that the diamond substrate layer 7 side becomes convex shape.

Moreover, large tensile stress is applied to each piece of columnar diamond 6 and cracks are generated in each piece of columnar diamond 6. With progress of generation of cracks, the columnar diamond 6 is broken and the diamond substrate layer 7 is separated from the foundation substrate 4 as illustrated in Fig. 12.

With increase in size of the diamond substrate layer 7, the stress of the diamond substrate layer 7 is released to the outside by breakage of the columnar diamond 6 even if the stress generated in the diamond substrate layer 7 becomes large. Therefore, occurrence of cracks in the diamond substrate layer 7 is prevented and it makes it possible to produce large diamond substrate 1 in this aspect as well.

Moreover, by using, for separation, stress generated by difference in lattice constant between the foundation substrate 4 and the diamond substrate layer 7 and/or stress generated by difference in thermal expansion coefficient between the foundation substrate 4 and the diamond substrate layer 7, a separate device, tool, and process for separation are not required after growth of the diamond substrate layer 7. Therefore, it becomes possible to simplify the process for producing the diamond substrate 1 and make the process of separation easier.

Note that, by setting the height direction of the columnar diamond 6 to the direction perpendicular to the plane (001) of the diamond single crystal that forms the diamond layer 5 and each piece of columnar diamond 6, breakage of the columnar diamond 6 by application of stress becomes smooth, which is preferable.

The aspect ratio of each piece of columnar diamond 6 illustrated in Figs. 7 to 13 is set to the value so as not to fill each piece of columnar diamond 6 when growing the diamond substrate layer 7, and more specifically, 5 or more is preferable.

Moreover, the diameter of each piece of columnar diamond 6 is set to about sub-micron to 5 µm, and it is preferable to set the diameter of the center of the columnar diamond in the height direction smaller than the diameter of the tip at both edges in order to more easily and smoothly break the columnar diamond 6.

After the diamond substrate layer 7 is separated from the foundation substrate 4, the diamond substrate layer 7 is polished to remove the remaining columnar diamond 6, sliced, and punched into circle to make a circular plate. Moreover, by bringing the circular plate to various processing such as lapping, polishing, and CMP, and mirror-polishing as necessary, the diamond substrate 1 is produced from the diamond substrate layer 7. Therefore, the thickness d7 of the diamond substrate layer 7 is set to be little thicker than t in consideration of polishing cost and the like.

As described, by producing the diamond substrate 1 from the diamond substrate layer 7, it becomes possible to produce large diamond substrate 1 with the diagonal line of 10 mm or more or the diameter of 0.4 inches or more. Moreover, since it is possible to achieve 300 seconds or less over the entire surface 2 as FWHM of the rocking curve by X-ray on the surface 2 of the diamond substrate 1, it becomes possible to provide the diamond substrate 1 with high quality.

Moreover, it is also possible to make FWHM 100 seconds or less or more preferably 50 seconds or less over the entire surface 2. Therefore, it becomes also possible to provide the diamond substrate 1 with much higher quality.

As described above, in the method for producing a diamond substrate 1 according to the present embodiment, the diamond substrate layer 7 is separated from the foundation substrate 4 by breaking the columnar diamond 6 during and after growth of the diamond substrate layer 7. Therefore, the stress of the diamond substrate layer 7 is released to the outside by breakage of the columnar diamond 6 even if stress is generated in the diamond substrate layer 7. Therefore, occurrence of crystal skew in the diamond substrate layer 7 is reduced, it becomes possible to reduce the difference between the highest point and the lowest point in the thickness direction of the diamond substrate 1 to more than 0 µm and 485 µm or less as illustrated in Figs. 2 to 4, and it is possible to reduce the variation of the angle of the crystal axis 3 over the entire surface 2 of the diamond substrate 1 to more than 0° and 3.00° or less.

In addition, since the stress of the diamond substrate layer 7 is released to the outside by breakage of the columnar diamond 6, generation of cracks in the diamond substrate layer 7 and the diamond substrate 1 is prevented.

Next, the second embodiment of a method for producing a diamond substrate according to the present embodiment will be described in detail with reference to Figs. 14 to 31. Note that, the same reference numerals are given to the parts same as in the first embodiment described above and repetitive description is omitted or simplified. First, as illustrated in Figs. 14 to 17, a foundation substrate 8 or 9 is prepared. The foundation substrate 8 or 9 is made of diamond single crystal. The diamond single crystal is any of Ia type, Ib type, IIa type, and IIb type.

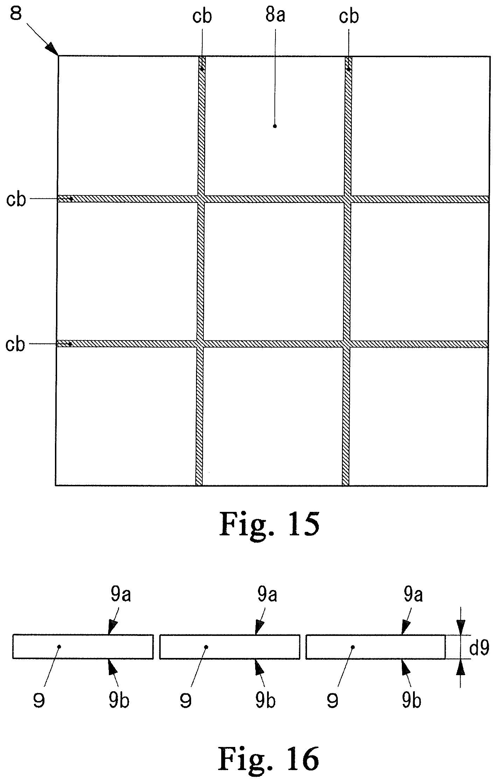

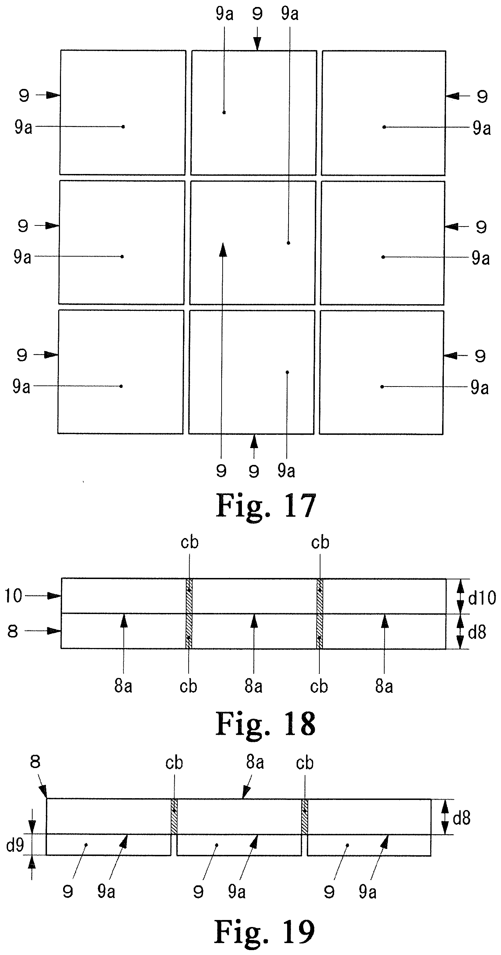

As a foundation substrate, single foundation substrate 8 as illustrated in Figs. 14 and 15 or several foundation substrates 9 as illustrated in Figs. 16 and 17 is/are used. When several foundation substrates 9 are prepared, it is preferable that the shape of the plane direction of each foundation substrate 9 be formed in square shape as illustrated in Fig. 17 and that each foundation substrate 9 be arranged in tile shape so as to minimize the gap between the foundation substrates 9 as much as possible.

As illustrated in Fig. 19, single foundation substrate 8 may be produced on the surface of the several foundation substrates 9 by using the several foundation substrates 9 as base substrates (hereinafter referred to as base substrate 9 as necessary), growing diamond single crystal over each surface of the base substrate 9 (in Fig. 19, over one surface 9a), and bringing each diamond single crystal grown over the surface of each base substrate 9 into coalescence to be coupled. Since physical formation of little gap between the base substrates 9 cannot be avoided, a linkage boundary cb is formed along the gap in the area of the foundation substrate 8 formed by coalescence above the gap. However, in the present embodiment, a substrate with a linkage boundary cb is also used for a foundation substrate. After the several foundation substrates 8 are formed, the base substrate 9 may be left as illustrated in Fig. 19 or may be separated as illustrated in Fig. 14.

In addition, as the foundation substrate 8 or 9, a substrate with at least one surface 8a or 9a mirror-polished is used. In the process of growing a diamond layer described later, a diamond layer is grown and formed over the mirror-polished surface (over one surface 8a or 9a).

It is preferable that mirror-polishing be performed with the surface roughness Ra of 10 nm or less. In the case in which Ra of one surface 8a or 9a is over 10 nm, it leads to deterioration of quality of the diamond layer to be grown over one surface 8a or 9a.

After the foundation substrate 8 or 9 is prepared, a diamond layer 10 made of diamond single crystal is grown and formed over one surface 8a or 9a as illustrated in Fig. 18, 20, or 21. When single foundation substrate 8 is used, a substrate with linkage boundary cb may be used as described above. Therefore, the diamond layer 10 is formed over the linkage boundary by each growth method described above, and an area with lowered crystal quality is formed over the diamond layer 10 as well. That is, a linkage boundary cb is formed in the diamond layer 10 as well following the linkage boundary cb of the foundation substrate 8, but it is allowed in the present embodiment.

When single foundation substrate 8 is produced with several foundation substrates 9 as base substrates, it becomes possible to reduce the area of the linkage boundary cb formed in the single foundation substrate 8 by making each foundation substrate 9 in square shape and further arranging them in tile shape so as to minimize the gap between the foundation substrates 9 as descried above.

Next, the diamond layer 10 is grown. The thickness d10 of the diamond layer 10 illustrated in Fig. 18, 20, or 21 is set to the height of the columnar diamond to be formed and it is preferable that the diamond layer 10 be grown in the thickness of 30 µm or more and 500 µm or less.

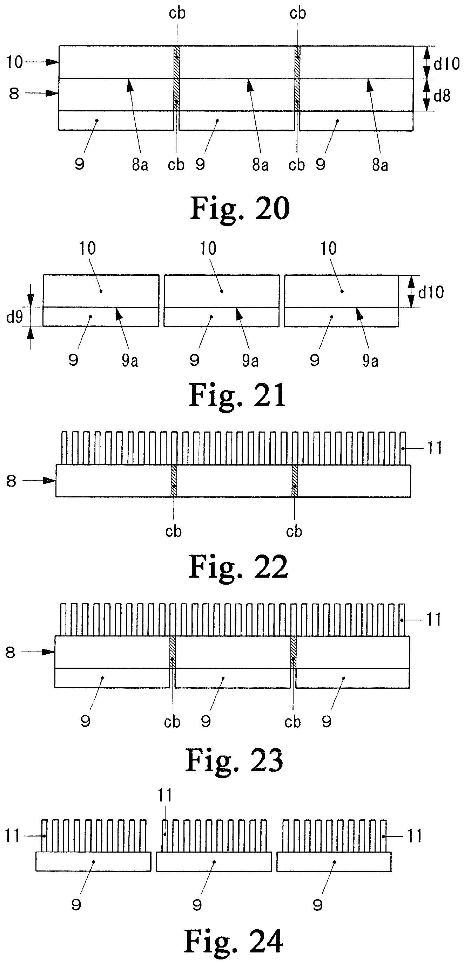

Next, as illustrated in Figs. 22 to 25, several pieces of columnar diamond 11 are formed from the diamond layer 10.

When single foundation substrate 8 is used as described above, since the existence of the linkage boundary cb in the diamond layer 10 is allowed, the columnar diamond 11 is formed also from the crystal of the linkage boundary cb. However, it becomes possible to significantly reduce the number of linkage boundary cb to reduce the number of defects by forming the linkage boundary cb in the columnar diamond 11.

Note that, several pieces of columnar diamond 11 may be formed by preliminarily making the thickness d8 or d9 of the foundation substrate 8 or 9 thicker by the thickness d10 and performing etching or laser process on the foundation substrate 8 or 9 by the thickness d10. It becomes possible to reduce the number of process of producing the diamond layer 10 by preliminarily making the thickness of the foundation substrate 8 or 9 thicker.

As descried above, several pieces of columnar diamond 11 made of diamond single crystal are formed over one surface 8a or 9a of the foundation substrate 8 or 9.

Next, the diamond substrate layer 7 is grown and formed at the tip of the columnar diamond 11. Then, it becomes possible to start coalescence of the diamond single crystal grown from each piece of columnar diamond 11 at the same timing by growing in the lateral direction against the height direction of each piece of columnar diamond 11.

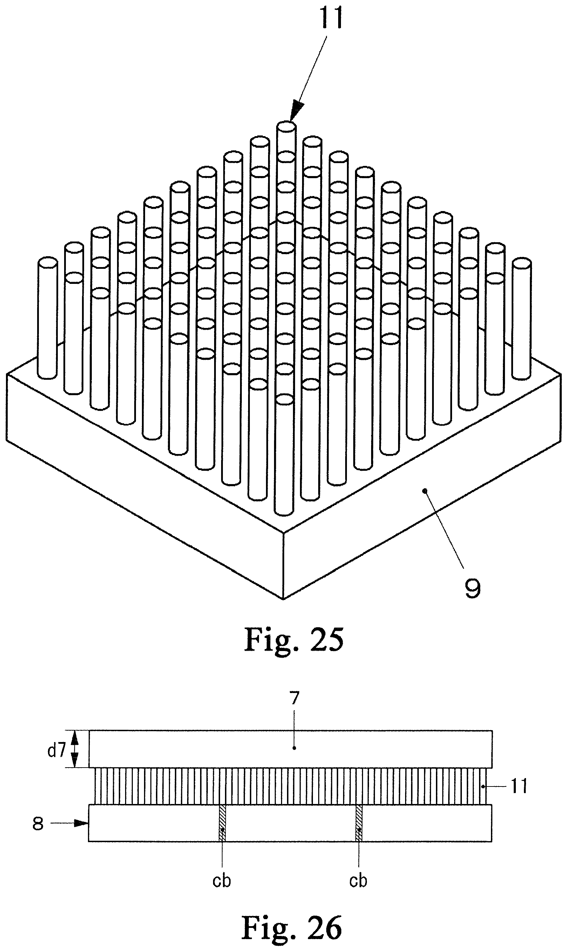

By bringing the diamond single crystal grown from each piece of columnar diamond 11 into coalescence, the diamond substrate layer 7 is produced as illustrated in Figs. 26 to 28.

Moreover, quality of the surface of the diamond substrate layer 7 is improved by setting the pitch between pieces of the columnar diamond 11 to the distance (pitch) to be the same as in growth of nucleus of diamond single crystal and growing diamond single crystal from each piece of columnar diamond 11, and it becomes possible to achieve FWHM of 300 seconds or less over the entire surface.

Moreover, FWHM can be 100 seconds or less or more preferably 50 seconds or less over the entire surface.

Note that, quality of the surface of the diamond substrate layer 7 is improved and it has become possible to achieve FWHM of 300 seconds or less by setting the diameter and the pitch of the columnar diamond 11 to 10 µm or less.

The value of the pitch between pieces of the columnar diamond 11 can be selected as appropriate.

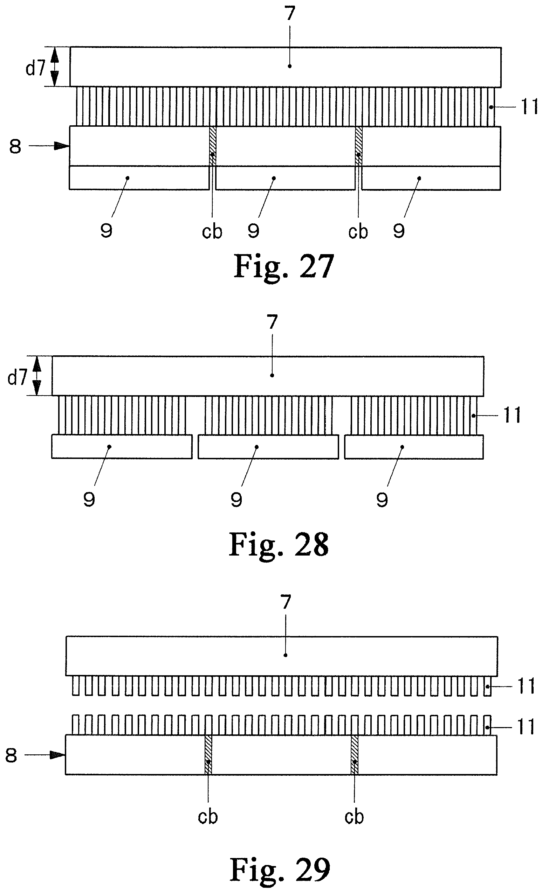

After the diamond substrate layer 7 is formed, the diamond substrate layer 7 is separated from the foundation substrate 8 or 9 at the columnar diamond 11 as illustrated in Figs. 29 to 31. In the present embodiment, action and external force are applied to the columnar diamond 11 from outside to break the columnar diamond 11 by the action and the external force to separate the diamond substrate layer 7 from the foundation substrate 8 or 9.

As a method for breaking the columnar diamond 11, for example, the side surface of the columnar diamond 11 may be irradiated with laser or external force may be applied by sharp and tiny blade edge to break the columnar diamond 11. The columnar diamond 11 is broken and the diamond substrate layer 7 is separated from the foundation substrate 8 or 9 by such a process.

Note that, by setting the height direction of the columnar diamond 11 to the direction perpendicular to the plane (001) of the diamond single crystal that forms the diamond layer 10 and each piece of columnar diamond 11, the columnar diamond 11 is smoothly broken by action and external force from outside, which is preferable.

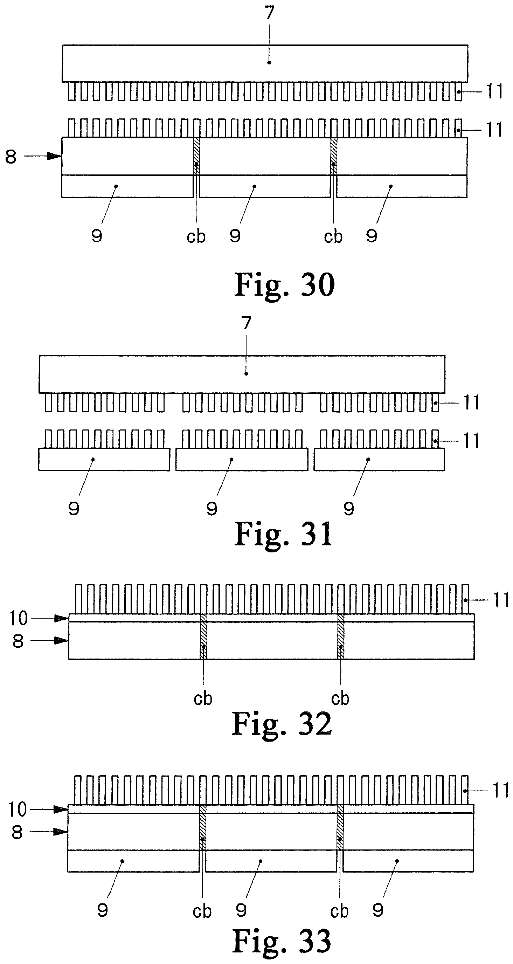

In addition, it is preferable that the thickness d10 of the diamond layer 10 illustrated in Fig. 18, 20, or 21 be set to the height of the columnar diamond 11 to be formed, and it is preferable to grow with the thickness of 30 µm or more and 500 µm or less. Note that, as illustrated in Fig. 32, 33, or 34, the columnar diamond 11 may be formed with the diamond layer 10 corresponding to the thickness of a part of the bottom of the thickness d10 left.

The aspect ratio of each piece of columnar diamond 11 is set to the value that does not fully fill each piece of columnar diamond 11 when the diamond substrate layer 7 is grown and, more specifically, 5 or more is preferable.

Moreover, the diameter of each piece of columnar diamond 11 is set to about sub-micron to 5 µm, and it becomes possible to more easily and smoothly break the columnar diamond 11 with the diameter of the center of the columnar diamond 11 in the height direction smaller than the diameter of the tip of both edges, which is preferable.

After the diamond substrate layer 7 is separated from the foundation substrate 8 or 9, the diamond substrate layer 7 is polished to remove the remaining columnar diamond 11, sliced, and punched into a desirable substrate shape. Moreover, by bringing the punched substrate to various processing such as lapping, polishing, and CMP, and mirror-polishing as necessary, the diamond substrate 1 is produced from the diamond substrate layer 7. Therefore, the thickness d7 of the diamond substrate layer 7 is set to be little thicker than the t in consideration of polishing cost and the like.

As descried, it becomes possible to produce the large diamond substrate 1 with the diagonal line of 10 mm or more or the diameter of 0.4 inches or more by producing the diamond substrate 1 from the diamond substrate layer 7. Moreover, since it is possible to achieve 300 seconds or less over the entire surface 2 as FWHM of the rocking curve by X-ray on the surface 2 of the diamond substrate 1, it becomes possible to produce the diamond substrate 1 with high quality.

Moreover, FWHM can be 100 seconds or less, or more preferably 50 seconds or less over the entire surface 2. Therefore, it becomes also possible to provide the diamond substrate 1 with much higher quality.

In addition, when several pieces of columnar diamond 11 are formed on one surface 8a with single foundation substrate 8, it becomes possible to significantly reduce the number of linkage boundary cb to reduce the number of defects by forming the columnar diamond 11 even if there is a linkage boundary cb in the foundation substrate 8. Therefore, it becomes possible to grow the diamond substrate 1 without linkage boundary cb without being influenced by the linkage boundary cb of the foundation substrate 8. Therefore, it becomes possible to use a diamond single crystal substrate with linkage boundary cb for the foundation substrate 8 and utility of production is improved.

Even if stress is generated in the diamond substrate layer 7 as described above, the stress is released to the outside by breaking the columnar diamond 11 after the diamond substrate layer 7 is grown. Therefore, occurrence of crystal skew in the diamond substrate layer 7 is reduced. It becomes possible to reduce the difference between the highest point and the lowest point in the thickness direction of the diamond substrate layer 7 to more than 0 µm and 485 µm or less and it is possible to reduce the variation of the angle of the crystal axis 3 over the entire surface of the diamond substrate to more than 0° and 3.00° or less as illustrated in Figs. 2 to 4 by producing the diamond substrate 1 from the diamond substrate layer 7.

In the diamond substrate and the method for producing the same according to the present invention, it becomes possible to preliminarily reduce the difference between the highest point and the lowest point in the thickness direction of the diamond substrate 1 to more than 0 µm and 485 µm or less and it becomes possible to reduce the angle variation of the crystal axis 3 over the entire surface 2 of the diamond substrate 1 to more than 0° and 3.00° or less. Therefore, since it is possible to reduce influence of the variation of the crystal axis 3 of the diamond substrate 1 to the crystal axis of the semiconductor film formed over the entire surface 2 of the diamond substrate 1, angle variation of the crystal axis of the semiconductor film is reduced and it becomes also possible to reduce occurrence of in-plane variation of characteristics of the semiconductor film. At the same time, since it becomes possible to keep the temperature in the diamond substrate 1 more constant when heating a functional thin film (for example, semiconductor film and the like) in formation thereof, it becomes also possible to reduce occurrence of in-plane variation of characteristics of the semiconductor film.

### DESCRIPTION OF REFERENCE SIGNS

- 1: Diamond substrate
- 2: Surface of diamond substrate
- 3: Crystal axis
- 4, 8, 9: Foundation substrate
- 5, 10: Diamond layer
- 6, 11: Columnar diamond
- 7: Diamond substrate layer
- 4a, 8a, 9a: One surface of foundation substrate
- 4b, 8b, 9b: Back surface of foundation substrate
- C: Center axis of diamond substrate
- ΔH: Amount of warpage of diamond substrate
- t: Thickness of diamond substrate
- d4, d8, d9: Thickness of foundation substrate
- d5, d10: Thickness of diamond layer
- d7: Thickness of diamond substrate layer
- cb: Linkage boundary

## Claims

1. A diamond substrate made of diamond single crystal, wherein
a difference between a highest point and a lowest point in a thickness direction of the diamond substrate is more than 0 µm and 485 µm or less, and
a variation of an angle of a crystal axis over an entire surface of the diamond substrate is more than 0° and 3.00° or less.

2. The diamond substrate according to claim 1, wherein
the difference is more than 0 µm and 130 µm or less and the variation of the angle of the crystal axis is more than 0° and 0.59° or less.

3. The diamond substrate according to claim 1 or 2, wherein
the difference is more than 0 µm and 65 µm or less and the variation of the angle of the crystal axis is more than 0° and 0.30° or less.

4. The diamond substrate according to any one of claims 1 to 3, wherein
the diamond substrate is simply warped from an outer edge toward a center, and
the difference is an amount of warpage of the outer edge and the center.

5. The diamond substrate according to any one of claims 1 to 3, wherein
the diamond substrate is not-simply warped from an outer edge toward a center, and
the difference is an amount of warpage of the outer edge and the highest point.

6. The diamond substrate according to any one of claims 1 to 3, wherein the diamond substrate has a wave.

7. The diamond substrate according to any one of claims 1 to 6, wherein a surface roughness Ra of the surface is less than 1 nm.

8. The diamond substrate according to claim 7, wherein the surface roughness Ra is 0.1 nm or less.

9. The diamond substrate according to any one of claims 1 to 8, wherein
a shape of the diamond substrate in a plane direction is a square shape, a circular shape, or a circular shape with an orientation flat surface, and
a length of a diagonal line is 10 mm or more in case of square shape and a diameter is 0.4 inches or more in case of circular shape.

10. The diamond substrate according to claim 9, wherein the length of the diagonal line is 50.8 mm or more or the diameter is 2 inches or more.

11. The diamond substrate according to claim 9 or 10, wherein the length of the diagonal line is 50.8 mm or more and 203.2 mm or less or the diameter is 2 inches or more and 8 inches or less.

12. The diamond substrate according to any one of claims 1 to 11, wherein FWHM (full width at half maximum) of an X-ray rocking curve in the surface is 300 seconds or less over the entire surface.

13. The diamond substrate according to claim 12, wherein the FWHM is 100 seconds or less over the entire surface.

14. The diamond substrate according to claim 12 or 13, wherein the FWHM is 50 seconds or less over the entire surface.

15. The diamond substrate according to any one of claims 1 to 14, wherein a thickness of the diamond substrate is 0.05 mm or more and 3.0 mm or less.

16. The diamond substrate according to claim 15, wherein the thickness is 0.3 mm or more and 3.0 mm or less.

17. The diamond substrate according to claim 15 or 16, wherein the thickness of the diamond substrate is 0.5 mm or more and 0.7 mm or less.

18. A method for producing a diamond substrate, comprising:
preparing a foundation substrate;
forming several pieces of columnar diamond made of diamond single crystal over one surface of the foundation substrate;
growing diamond single crystal from a tip of each piece of columnar diamond and bringing each piece of diamond single crystal grown from the tip of each piece of columnar diamond into coalescence to form a diamond substrate layer;
separating the diamond substrate layer from the foundation substrate; and
producing a diamond substrate from the diamond substrate layer, wherein
a difference between a highest point and a lowest point in a thickness direction of the diamond substrate is more than 0 µm and 485 µm or less, and
a variation of an angle of a crystal axis over an entire surface of the diamond substrate is more than 0° and 3.00° or less.

19. The method for producing a diamond substrate according to claim 18, wherein the difference is more than 0 µm and 130 µm or less and the variation of the angle of the crystal axis is more than 0° and 0.59° or less.

20. The method for producing a diamond substrate according to claim 18 or 19, wherein the difference is more than 0 µm and 65 µm or less and the variation of the angle of the crystal axis is more than 0° and 0.30° or less.

21. The method for producing a diamond substrate according to any one of claims 18 to 20, wherein the foundation substrate and the diamond substrate layer are separated from each other by generating a stress on the columnar diamond and breaking the columnar diamond.

22. The method for producing a diamond substrate according to claim 21, wherein the stress is a stress generated by a difference in lattice constant between the foundation substrate and the diamond substrate layer and/or a stress generated by a difference in thermal expansion coefficient between the foundation substrate and the diamond substrate layer.

23. The method for producing a diamond substrate according to any one of claims 18 to 20, wherein the foundation substrate is single or several foundation substrate(s) made of diamond single crystal.

24. The method for producing a diamond substrate according to claim 23, comprising:
growing diamond single crystal over each surface of the several foundation substrates;
producing the single foundation substrate by bringing each piece of diamond single crystal grown over the surface of each foundation substrate into coalescence; and
forming the several pieces of columnar diamond over one surface of the single foundation substrate.

25. The method for producing a diamond substrate according to any one of claims 18 to 24, wherein an aspect ratio of each piece of columnar diamond is 5 or more.

26. The method for producing a diamond substrate according to any one of claims 18 to 25, wherein a diameter and a pitch of the columnar diamond are each 10 µm or less.

27. The method for producing a diamond substrate according to any one of claims 18 to 26, wherein a surface roughness Ra of one surface of the foundation substrate is 10 nm or less.

28. The method for producing a diamond substrate according to any one of claims 18 to 27, wherein a height direction of the columnar diamond is set to a direction perpendicular to a plane (001) of the diamond single crystal that forms the columnar diamond.

29. The method for producing a diamond substrate according to any one of claims 18 to 28, wherein
the columnar diamond has a columnar shape, and
a diameter of a center of the columnar diamond in a height direction is smaller than a diameter at a tip.
